Europäisches Patentamt

European Patent Office

Office européen des brevets

(19)

(11) Veröffentlichungsnummer : **0 086 434**
**B1**

(12)     # EUROPÄISCHE PATENTSCHRIFT

(45) Veröffentlichungstag der Patentschrift :
09.10.85

(21) Anmeldenummer : 83101155.6

(22) Anmeldetag : 07.02.83

(51) Int. Cl.⁴ : **H 04 Q   3/52, H 03 K 17/62,
H 03 K 19/086**

(54) **Koppelanordnung.**

(30) Priorität : **12.02.82 DE 3204900**

(43) Veröffentlichungstag der Anmeldung :
**24.08.83 Patentblatt 83/34**

(45) Bekanntmachung des Hinweises auf die Patenterteilung : **09.10.85 Patentblatt 85/41**

(84) Benannte Vertragsstaaten :
**AT CH DE FR GB IT LI NL SE**

(56) Entgegenhaltungen :
EP-A- 0 028 415
DE-A- 2 719 257
IEEE JOURNAL OF SOLID-STATE CIRCUITS, Band SC-14, Nr. 5, Oktober 1979, Seiten 829-832, IEEE New York, USA W. BRAECKELMANN et al.: "A masterslice LSI for subnanosecond random logic"
ELECTRONIQUE INDUSTRIELLE, Nr. 11, 1. März 1981, Seiten 37-38, Paris, FR. "Multiplexeurs ultra-rapides pour traitement de données"
WIRELESS WORLD, Band 84, Nr. 1507, März 1978, Seiten 47-49, Haywards Heath, GB. B. HOLDSWORTH et al.: "Logic-design-11"
N.E.C. RESEARCH AND DEVELOPMENT, Nr. 60, Januar 1981, Seiten 6-13, Tokyo, JP. K. SAITOH et al.: "A large size routing switcher for television broadcasting stations"

(73) Patentinhaber : **Siemens Aktiengesellschaft
Berlin und München Wittelsbacherplatz 2
D-8000 München 2 (DE)**

(72) Erfinder : **Rehm, Hans, Dipl.-Ing.
Wildenfelserstrasse 19
D-8000 München 60 (DE)**
Erfinder : **Donig, Günter
Zeisigstrasse 2
D-8012 Ottobrunn (DE)**

## Beschreibung

Die Erfindung betrifft eine Koppelanordnung zur Vermittlung bzw. Verteilung von Kommunikationssignalen in Nachrichtenvermittlungssystemen.

Neuere Entwicklungen der Kommunikationstechnik führen zu Nachrichtenvermittlungssystemen, über die neben (gewissermaßen schmalbandigen) Fernsprechsignalen und ggf. Datenkommunikationssignalen auch (demgegenüber breitbandige) Fernseh- u./o. Bildfernsprechsignale übermittelt werden, wozu, wie dies etwa aus DE-PS-2 421 002, DE-OS-2 538 638, DE-OS-2 922 418 bekannt ist, in der Vermittlungsstelle neben einem Schmalbandkoppelnetzwerk auch wenigstens ein Breitbandkoppelnetzwerk vorgesehen wird, wobei diese Koppelnetzwerke mit Hilfe einer gemeinsamen Steuereinrichtung gesteuert werden können.

Bei der Realisierung solcher Nachrichtenvermittlungssysteme ist man bestrebt, die einzelnen Systemkomponenten, so auch die Koppelnetzwerke, mit möglichst geringem Aufwand zu erstellen, was indessen in der Praxis der Realisierung eines Breitbandkoppelnetzwerks insbesondere mit zunehmender Breitbandigkeit sowie zunehmender Anzahl von Zubringerleitungen bzw. Abnehmerleitungen auf Schwierigkeiten stößt. Aufgabe der Erfindung war es daher, eine Koppelanordnung zur Vermittlung bzw. Verteilung von breitbandigen Kommunikationssignalen anzugeben, die zu wirtschaftlich tragbaren Kosten mit heute verfügbaren Bausteinen realisierbar ist.

Eine solche Koppelanordnung zur Vermittlung bzw. Verteilung von Kommunikationssignalen in Nachrichtenvermittlungssystemen ist erfindungsgemäß gekennzeichnet durch die Kombination der folgenden Merkmale :

die Koppelanordnung ist eine Breitband-Koppelanordnung mit in einer ECL-Technik realisierten Koppelpunktschaltkreisen, die durch in jeweils einen bestimmten Durchschaltzustand steuerbare Multiplexer gebildet sind,

die steuerbaren Multiplexer sind untereinander zu jeweils eine Abnehmer-Leitung und mehrere Zubringer-Leitungen aufweisenden mehrstufigen Koppelpunktpyramiden verbunden,

die steuerbaren Multiplexer jeweils einer Mehrzahl von Koppelpunktpyramiden sind auf einem Chip-Baustein zusammengefaßt.

Die Erfindung bringt den Vorteil mit sich, bei der Realisierung der Koppelanordnung weitgehend auf (z. B. aus IEEE Journal of Solid-State Circuits, 14 (1979) 5, 829 ... 832 ; oder auch Electronique Industrielle, n° 11/1.3.81, 37 ... 38) als für schnelle Telekommunikationssysteme und digitale Videosysteme geeignet bekannte sogenannte LSI-Masterslice-Technologie und damit auf in Form sogenannter LSI-Masterslice-Bausteine mit Zellen (vor)verdrahtung nach Maßgabe von Standard-Zellenbibliotheken bereits vorhandene, mit einer Mehrzahl von Multiplexern zu versehende LSI-Chip-Bausteine zurückgreifen zu können und damit ohne großen zusätzlichen Aufwand zu einer für die Durchschaltung von bis in den Hundert-Mbit/s-Bereich hineinreichenden Breitbandsignalen, beispielsweise von 140-Mbit/s- bzw. 70-MHz-Signalen oder sogar 270-Mbit/s-Signalen, geeigneten Koppelanordnung zu gelangen ; in weiterer Ausgestaltung der Erfindung kann daher ein solcher Chip-Baustein vorteilhafterweise durch einen eine Mehrzahl von steuerbaren Multiplexern enthaltenden Masterslice-Chip gebildet sein, insbesondere durch einen Chip der Masterslice-Gate-Array-Familie Siemens SH100 mit $2 \times 4$-bit-Multiplexer-Zellen HMX05. Dabei kann, wenn in weiterer Ausgestaltung der Erfindung die Koppelpunktschaltkreise von acht jeweils eine Abnehmer-Leitung und sechszehn gemeinsame Zubringer-Leitungen aufweisenden Koppelpunktpyramiden auf einem Masterslice-Baustein vereinigt sind, jede sechzehn Zubringer-Leitungen und eine Abnehmer-Leitung aufweisende Koppelpunktpyramide mit zwei jeweils zwei 4-Bit-Multiplexer aufweisenden 4-Bit-Multiplexer-Zellen und einer dritten, wenigstens einen 4-Bit-Multiplexer aufweisenden 4-Bit-Multiplexer-Zelle gebildet sein, was sich im Hinblick auf eine möglichst geringe Leistungs- und Wärmebelastung eines die Koppelpunktpyramide enthaltenden LSI-Bausteins als besonders vorteilhaft erwiesen hat.

Es sei an dieser Stelle bemerkt, daß es aus WIRELESS WORLD 84 (1978) 1507, March 1978, 47 ... 49, bekannt ist, eine Mehrzahl von Multiplexern zu einer eine Ausgangsleitung und eine Vielzahl von Eingangsleitungen aufweisenden Multiplexpyramide zusammenzuschalten, die, von einem Taktzähler gesteuert, die Eingangsleitungen zyklisch abtastet und damit die Eingangssignale im Zeitmultiplex bündelt ; nähere Berührungspunkte mit den der Erfindung zugrunde liegenden Problemen einer kostengünstigen Realisierung von Breitbandkoppelanordnungen zur Vermittlung bzw. Verteilung von Kommunikationssignalen in Nachrichtenvermittlungssystemen sind dabei indessen nicht gegeben.

In weiterer Ausgestaltung der Erfindung kann zusätzlich auf dem die Koppelpunktpyramiden enthaltenden Chip-Baustein bei jeder Koppelpunktpyramide ein zusätzlicher Umschaltkoppelpunkt vorgesehen sein, der mit seiner einen Schaltstrecke in die Abnehmer-Leitung der Koppelpunktpyramide eingefügt ist. Dies eröffnet zum einen die Möglichkeit, daß mit der anderen Zubringer-Klemme des zusätzlichen Umschaltkoppelpunktes die Abnehmer-Leitung einer weiteren solchen Koppelpunktpyramide verbunden wird, womit eine entsprechende Erweiterung der Koppelanordnung erzielt wird, und zwar sowohl unter Vermeidung einer ausgangsseitigen einfachen (wired-or-) Vielfachschaltung von Koppelpunktpyramiden, bei der bei in den Hundert-Mbit/s-Bereich hineinreichenden Breitbandsignalen die Leitungslängen nicht mehr vernachlässigbar klein gegenüber der Wellenlänge wären und bei der daher unzulässige Reflexionen und nachfolgende Signalverfälschungen auftreten würden, als auch unter Vermeidung externer, nicht auf dem Chip-Baustein integrierter Verknüpfungsschaltungen, wodurch eine Realisierung von zwei oder auch mehr derartige Chip-Bausteine tragenden Schaltungsplatinen zumindest wesentlich erleichtert wird. Des weiteren kann bei einer Vermittlung bzw. Verteilung von Kommunikationssignalen in Form von frequenzmodulierten Signalen bei Nichtdurchschaltung eines solchen Kommunikationssignals zu der Abnehmer-Klemme der Koppelpunktpyramide über die andere Zubringer-Klemme des zusätzlichen Umschaltkoppelpunktes ein unmoduliertes Trägersignal zugeführt werden, wodurch vorteilhafterweise ein etwaiges Übersprechen anderer in der Koppelanordnung auftretender Kommunikationssignale an der genannten Abnehmerklemme mit Sicherheit unterdrückt wird.

An dieser Stelle sei bemerkt, daß es aus N.E.C. RESEARCH AND DEVELOPMENT, January 1981, No. 60, 6 ... 13, bekannt ist, bei einer mit in einfacher Crosspoint-Technik gehaltenen, mit Hybrid-ICs aufgebauten einstufigen Koppelanordnung zur Verteilung von Videosignalen auf einer eine Mehrzahl solcher ausgangsseitig vielfachgeschalteter Crosspoint-ICs tragenden Crosspoint-Karte ausgangsseitig einen zusätzlichen einfachen Crosspoint vorzusehen, um auch eine Mehrzahl von Crosspoint-Karten ausgangsseitig vielfachschalten zu können. Nähere Berührungspunkte mit einer Realisierung einer Breitband-Koppelanordnung durch mit steuerbaren Multiplexern gebildete mehrstufige Koppelpunktpyramiden sind dabei indessen nicht gegeben.

Es sei ferner bemerkt, daß Umschaltkoppelpunktpyramiden für sich (z. B. aus DE-PS-582 206 oder aus DE-PS-1 115 775) bekannt sind und daß Koppelanordnungen mit Koppelpunktschaltkreisen in ECL-Technik für sich (z. B. aus DE-AS-2 828 662) bekannt sind ; nähere Berührungspunkte mit den der Erfindung zugrundeliegenden Problemen einer besonders kostengünstigen Realisierung von Breitbandkoppelnetzen sind auch hier nicht gegeben.

Anhand der Zeichnungen sei die Erfindung noch näher erläutert.

Dabei zeigt

Figur 1 ein Ausführungsbeispiel einer Koppelpunktpyramide gemäß der Erfindung ;

Figur 2 und Figur 3 verdeutlichen schaltungstechnische Einzelheiten von in dieser Koppelpunktpyramide vorgesehenen Koppelpunktschaltkreisen.

Figur 4 verdeutlicht eine Erweiterung einer solchen Koppelpunktpyramide, und

Figur 5 zeigt mehrere auf einem Chip zusammengefaßte Koppelpunktpyramiden mit zugehörigen Ansteuerschaltungen.

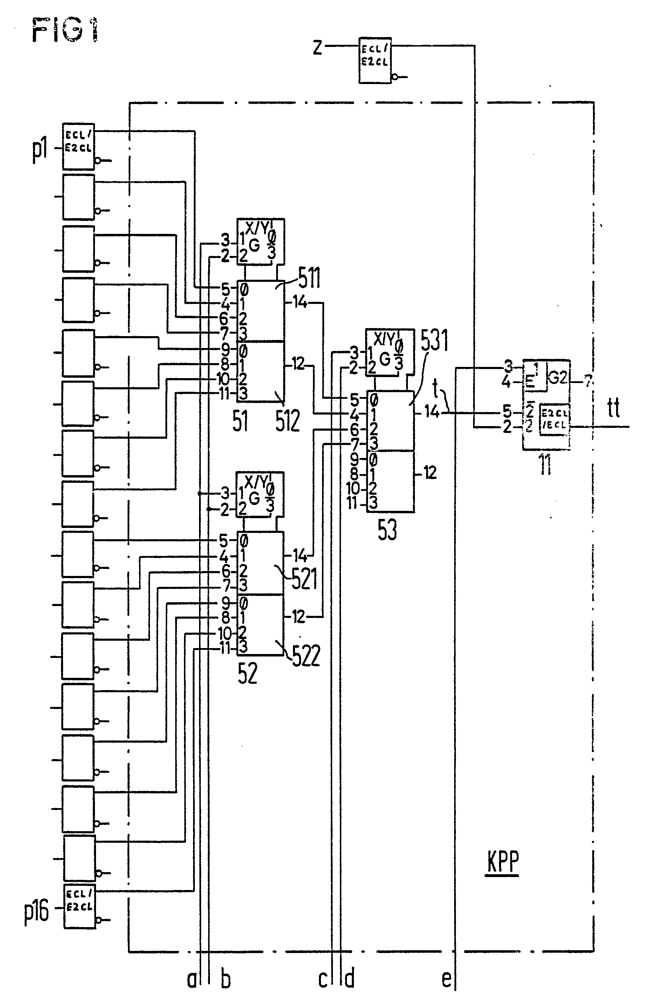

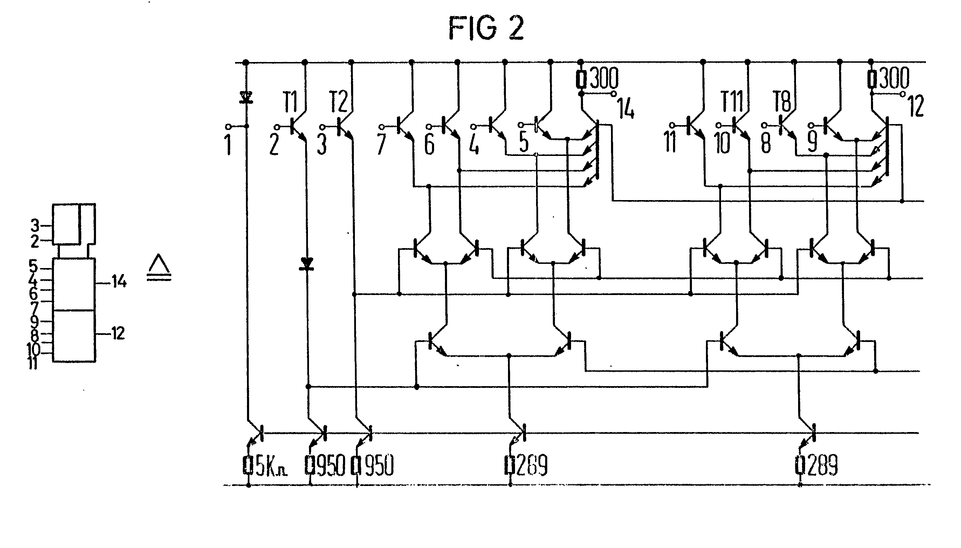

In der Zeichnung Fig. 1 ist schematisch in einem zum Verständnis der Erfindung erforderlichen Umfange ein Ausführungsbeispiel einer Koppelpunktpyramide KPP dargestellt, die, wie dies unten noch näher erläutert wird, zusammen mit weiteren solchen Koppelpunktpyramiden auf einem Masterslice-Chip-Baustein zu einer Breitband-Koppelanordnung gemäß der Erfindung zusammengefaßt sein möge. Diese Koppelpunktpyramide KPP, die im Beispiel sechzehn jeweils über eine Eingangspegelumsetzerstufe ECL/E2CL geführte Zubringer-Leitungen p1 ... p16 und eine über eine Ausgangspegelumsetzerstufe E2CL/ECL geführte Abnehmer-Leitung t-tt aufweist, ist mit zwei jeweils zwei 4-Bit-Multiplexer 511, 512 ; 521, 522 aufweisenden 4-Bit-Multiplexer-Zellen 51 ; 52 und einer dritten, einen 4-Bit-Multiplexer 531 aufweisenden 4-Bit-Multiplexer-Zelle 53 gebildet. Wie aus Fig. 1 ersichtlich ist, kann die dritte 4-Bit-Multiplexer-Zelle 53 genau wie die beiden anderen 4-Bit-Multiplexer-Zellen 51 und 52 jeweils zwei 4-Bit-Multiplexer aufweisen, von denen dann nur der eine ausgenutzt wird. Die steuerbaren Multiplexer-Zellen 51, 52, 53 können vorzugsweise durch in sogenannter $E^2CL$-Technik gehaltene Multiplexer-Zellen HMXO5 der (beispielsweise in den Siemens-Druckschriften « Integrated Circuits — SH100 Family — Design Kit — Cell Library », und « Gate-Arrays — Masken-Programmierbare Logikschaltungen », Ausgabe 1981, Bestell-Nr. B/2363, beschriebenen) $E^2CL$-100-Masterslice-Baustein-Familie Siemens SH100 gebildet sein, wobei beispielsweise die Koppelpunktschaltkreise von beispielsweise acht jeweils eine Abnehmer-Leitung und sechzehn gemeinsame Zubringer-Leitungen aufweisenden Koppelpunktpyramiden auf einem Masterslice-Baustein vereinigt sein können. Schaltungstechnische Einzelheiten einer solchen 4-Bit-Multiplexer-Zelle sind beispielsweise aus Fig. 2 ersichtlich. Die beiden 4-Bit-Multiplexer-Zellen 51 und 52 werden gemeinsam über zwei Binärsignalleitungen a, b mit zwei Steuerbits angesteuert, so daß die 4-Bit-Multiplexer 511, 512, 521, 522 sich jeweils in einem bestimmten Durchschaltezustand von vier möglichen Durchschaltezuständen befinden. In entsprechender Weise wird die 4-Bit-Multiplexer-Zelle 53 über zwei weitere Binärsignalleitungen c, d mit zwei weiteren Steuerbits angesteuert, so daß auch der 4-Bit-Multiplexer 531 sich jeweils in einem bestimmten Durchschaltezustand von vier möglichen Durchschaltezuständen befindet.

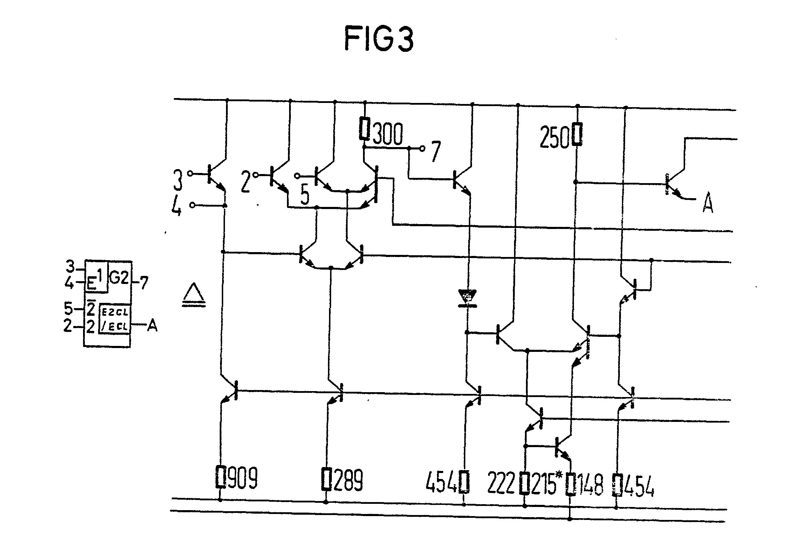

Wie aus Fig. 1 ersichtlich wird, kann bei jeder Koppelpunktpyramide KPP ein zusätzlicher Umschaltkoppelpunkt vorgesehen sein, der mit seiner einen Schaltstrecke in die Abnehmer-Leitung t-tt der Koppelpunktpyramide KPP eingefügt ist. Dieser Umschaltkoppelpunkt kann, wie dies auch in Fig. 1 angedeutet ist, durch eine 2-Bit-Multiplexer-Zelle 11 gebildet sein, beispielsweise durch eine 2-Bit-Multiplexer-Zelle des Typs Siemens SH100-HMXA1 (bzw., bei Invertierung des Ausgangssignals, des Typs SH100-HMXA2) ; schaltungstechnische Einzelheiten einer solchen 2-Bit-Multiplexer-Zelle sind beispielsweise aus Fig. 3 ersichtlich. Diese 2-Bit-Multiplexer-Zelle 11

kann über eine zusätzliche Binärsignalleitung e durch ein zusätzliches Steuerbit gesteuert werden, so daß sie sich jeweils in ihrem einen oder in ihrem anderen Durchschaltezustand befindet.

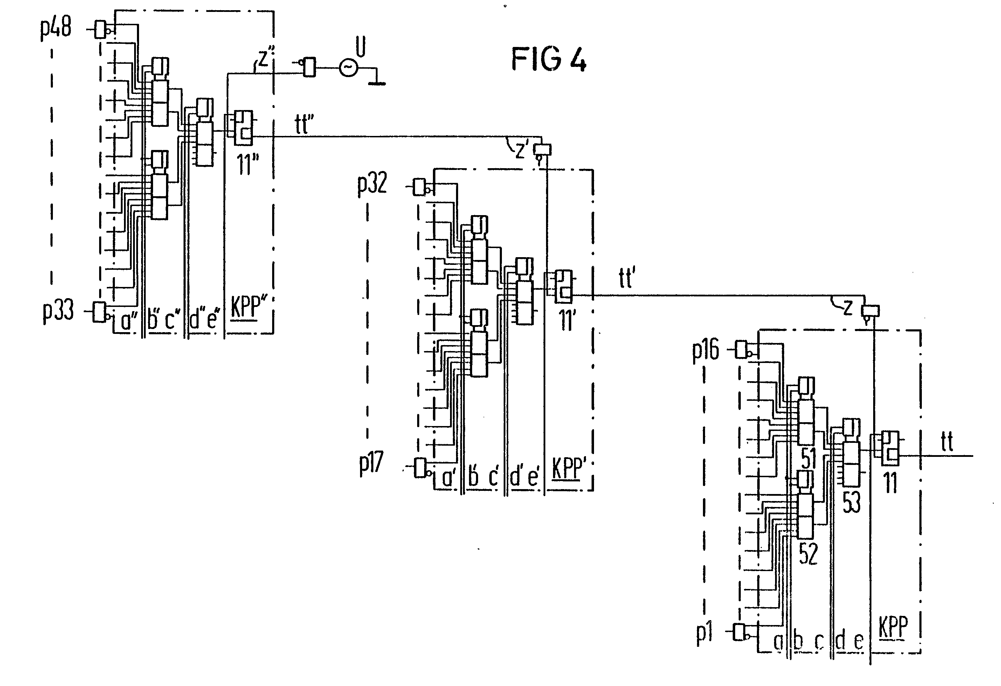

Wie dies in Fig. 4 im einzelnen dargestellt ist, kann die andere Zubringer-Klemme des zusätzlichen Umschaltkoppelpunktes 11 mit der an den zusätzlichen Eingang z der Koppelpunktpyramide KPP herangeführten Abnehmer-Leitung tt′ einer weiteren Koppelpunktpyramide KPP′ verbunden sein, womit eine entsprechende Erweiterung der Koppelanordnung auf beispielsweise 32 Zubringer-Leitungen p1 ... p32 erzielt wird ; diese Erweiterung kann in entsprechender Weise bei der genannten weiteren Koppelpunktpyramide KPP′ auf beispielsweise 48 (bzw. weitere Vielfache von 16) Zubringer-Leitungen p1 ... p48 ausgedehnt werden.

Bei einer Vermittlung bzw. Verteilung von Kommunikationssignalen in Form von frequenzmodulierten Signalen kann bei Nichtdurchschaltung eines solchen Kommunikationssignals zu der Abnehmer-Leitung tt der Koppelpunktpyramide KPP über die andere Zubringer-Klemme des zusätzlichen Umschaltkoppelpunktes 11 auch ein unmoduliertes Trägersignal zugeführt werden, um so mit Sicherheit ein etwaiges Übersprechen anderer in der Koppelanordnung auftretender Kommunikationssignale an der Abnehmerleitung tt zu unterdrücken. Hierzu kann eine entsprechende Trägersignalquelle U direkt an den zusätzlichen Eingang z der Koppelpunktpyramide KPP oder, wie dies in Fig. 4 dargestellt ist, einer zu ihrem zusätzlichen Eingang z führenden weiteren Koppelpunktpyramide KPP″ angeschlossen sein.

Die Zeichnung Fig. 4 zeigt schematisch beide zuvor angesprochenen Alternativen, die dabei, wie dies auch aus Fig. 4 ersichtlich wird, auch gemeinsam zur Anwendung kommen können.

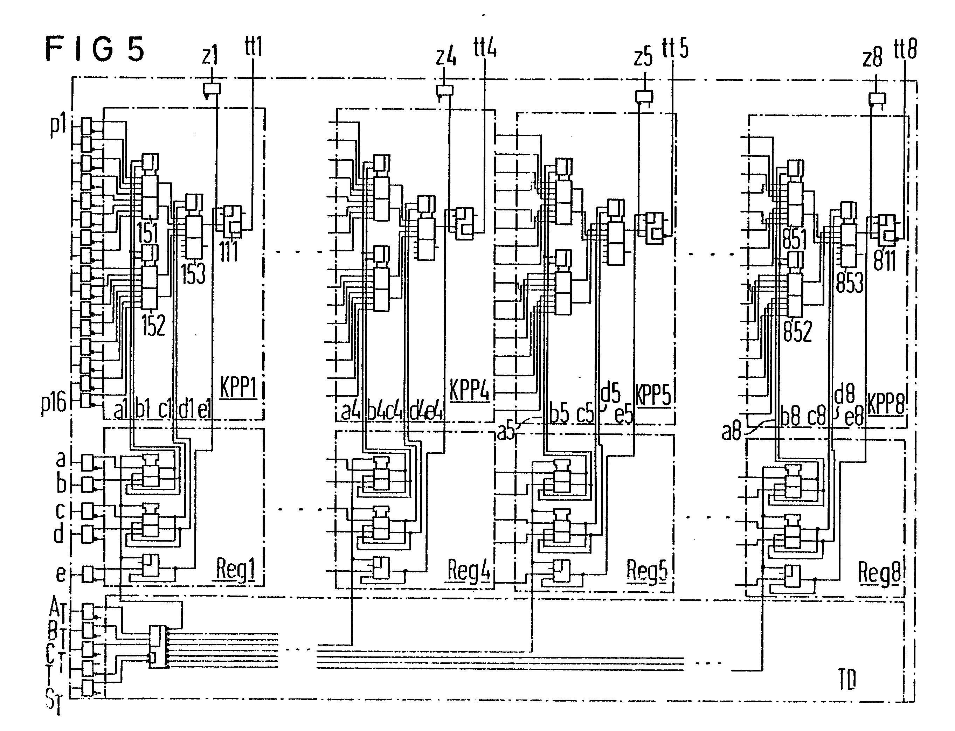

Die Zusammenfassung der steuerbaren Multiplexer jeweils einer Mehrzahl von Koppelpunktpyramiden auf einem Chip-Baustein verdeutlicht die Zeichnung Fig. 5. In Fig. 5 sind acht jeweils eine individuelle Abnehmer-Leitung tt1 ... tt4, tt5 ... tt8 und sechzehn gemeinsame Zubringer-Leitungen p1 ... p16 aufweisende Koppelpunktpyramiden KPP1 ... KPP4, KPP5 ... KPP8 dargestellt bzw. angedeutet, die, auf einem LSI-Baustein, vorzugsweise auf einem Gate-Array des Typs Siemens SH100, zusammengefaßt, einen Breitbandkoppelfeldbaustein 16/8 bilden. Dabei können, wie dies auch aus Fig. 5 ersichtlich ist, zur Verringerung der Belastung pro Zubringerpegelumsetzerstufe (beispielsweise des Typs Siemens SH100-HITE1) die Koppelpunktpyramiden in zwei Gruppen aufgeteilt sein, wobei die Koppelpunktpyramiden KPP1 ... KPP4 mit den nichtinvertierten Zubringersignalen und die Koppelpunktpyramiden KPP5 ... KPP8 mit den invertierten Zubringersignalen beaufschlagt werden — wobei die Invertierung dann am Ausgang der in der 2-Bit-Multiplexerzelle ... 811 (11 in Fig. 1) enthaltenen Abnehmerpegelumsetzerstufe E2CL/ECL (siehe Fig. 1) wieder rückgängig gemacht wird.

In entsprechender Weise können übrigens, wie dies ebenfalls aus Fig. 5 ersichtlich wird, auch den einzelnen Koppelpunktpyramiden KPP1 ... KPP4, KPP4 ... KPP8 zugehörige Ansteuerungsregister Reg1 ... Reg4, Reg5 ... Reg8 angesteuert werden, die in Fig. 5 unterhalb der Koppelpunktpyramiden dargestellt sind und von denen die Ansteuerleitungen a1, b1, c1, d1, e1 ; ... ; a4, b4, c4, d4, e4 ; a5, b5, c5, d5, e5 ; ... ; a8, b8, c8, d8, e8 (a, b, c, d, e in Fig. 1) zu der jeweils zugehörigen Koppelpunktpyramide führen. Diese Ansteuerregister Reg können, wie dies in Fig. 5 angedeutet ist, jeweils mit einer vier jeweils paarweise angesteuerte 2-Bit-Multiplexer enthaltenden 2-Bit-Multiplexer-Zelle vorzugsweise des Typs Siemens SH100-HMXO1 und einer einen 2-Bit-Multiplexer enthaltenden 2-Bit-Multiplexer-Zelle vorzugsweise des Typs Siemens SH100-HMXA4 gebildet sein, wobei die einzelnen Multiplexer jeweils durch Rückkopplung zu einer bistabilen Kippschaltung werden. Dabei können dann, wie dies aus Fig. 5 weiter ersichtlich ist, die Ansteuerregister teils, wie die Register Reg1 ... Reg4, mit nichtinvertierten Signalen und teils, wie die Register Reg5 ... Reg8, mit invertierten Signalen angesteuert werden — wobei der Invertierung dann durch eine entsprechend geänderte Zuordnung der Zubringer-Leitungen p1 ... p16 zu den Eingängen der gesteuerten 4-Bit-Multiplexer-Zellen der Koppelpunktpyramiden KPP5 ... KPP8 Rechnung getragen wird.

In Fig. 5 ist des weiteren noch angedeutet, daß die einzelnen Ansteuerregister Reg und damit die einzelnen Koppelpunktpyramiden KPP mit Hilfe eines ebenfalls auf dem LSI-Baustein befindlichen Taktdecoders TD gezielt angesteuert werden können. Der Taktdecoder TD weist dabei einen Demultiplexer vorzugsweise des Typs Siemens SH100-HDM81 auf, der, wie dies aus Fig. 5 ersichtlich wird, mit einer 3-Bit-Adresse $A_T$, $B_T$, $C_T$ des jeweiligen Registers und damit der jeweiligen Koppelpunktpyramide sowie mit einem Takt T und ggf. einem Chip-Bezeichnungssignal $S_T$ beaufschlagt wird.

Abschließend sei noch bemerkt, daß die Erfindung nicht an die vorstehend beschriebene Konfiguration von Multiplexer-Zellen gebunden ist, daß vielmehr auch andere Multiplexer-Strukturen zur Anwendung kommen können. So kann etwa anstelle der in Fig. 1 dargestellten, zwei 4-Bit-Multiplexer enthaltenden 4-Bit-Multiplexer-Zelle 53 des Typs SH100-HMXO5 beispielsweise eine vier 2-Bit-Multiplexer enthaltende 2-Bit-Multiplexer-Zelle des Typs SH100-HMXO6 Anwendung finden, bei der zwei mit einem Ansteuerbit gemeinsam angesteuerte 2-Bit-Multiplexer, deren insgesamt vier Demultiplex-Klemmen mit den insgesamt vier Multiplex-Klemmen der benachbarten 4-Bit-Multiplexer-Zellen (51, 52 in Fig. 1) verbunden sind, mit ihren insgesamt zwei Multiplex-Klemmen mit den beiden Demultiplex-Klemmen des mit seiner Multiplex-Klemme an der Pyramidenspitze liegenden, mit einem weiteren Ansteuerbit angesteuerten dritten 2-Bit-Multiplexers führen, während der vierte 2-Bit-Multiplexer ungenutzt bleibt. Dies ist indessen in den Zeichnungen nicht mehr dargestellt, da dies zum Verständnis der Erfindung nicht mehr erforderlich ist.

**Patentansprüche**

1. Koppelanordnung zur Vermittlung bzw. Verteilung von Kommunikationssignalen in Nachrichtenvermittlungssystemen, gekennzeichnet durch die Kombination der folgenden Merkmale :
die Koppelanordnung ist eine Breitband-Koppelanordnung mit in einer ECL-Technik realisierten Koppelpunktschaltkreisen (51, 52, 53), die durch in jeweils einen bestimmten Durchschaltzustand steuerbare Multiplexer (511, 512, 521, 522, 531) gebildet sind,
die steuerbaren Multiplexer (511, 512, 521, 522, 531) sind untereinander zu jeweils eine Abnehmer-Leitung (t-tt) und mehrere Zubringer-Leitungen (p1 ... p16) aufweisenden Koppelpunktpyramiden (KPP) verbunden,
die steuerbaren Multiplexer (511, 512, 521, 522, 531) jeweils einer Mehrzahl von Koppelpunktpyramiden (KPP1 ... KPP8) sind auf einem Chip-Baustein zusammengefaßt.

2. Koppelanordnung nach Anspruch 1, dadurch gekennzeichnet, daß der Chip-Baustein durch einen eine Mehrzahl von steuerbaren Multiplexern (511, 512, 521, 522, 531) enthaltenden Masterslice-Baustein gebildet ist.

3. Koppelanordnung nach Anspruch 2, dadurch gekennzeichnet, daß die Koppelpunktschaltkreise (151, 152, 153 ; ... ; 851, 852, 853) von acht jeweils eine Abnehmer-Leitung (tt1 ... tt8) und sechzehn gemeinsame Zubringer-Leitungen (p1 ... p16) aufweisenden Koppelpunktpyramiden (KPP1 ... KPP8) auf einem Masterslice-Baustein vereinigt sind.

4. Koppelanordnung nach Anspruch 2 oder 3, dadurch gekennzeichnet, daß jede sechzehn Zubringer-Leitungen (p1 ... p16) und eine Abnehmer-Leitung (t-tt) aufweisende Koppelpunktpyramide (KPP) mit zwei jeweils zwei 4-Bit-Multiplexer (511, 512 ; 521, 522) aufweisenden 4-Bit-Multiplexer-Zellen (51, 52) und einer dritten, wenigstens einen 4-Bit-Multiplexer (531) aufweisenden 4-Bit-Multiplexer-Zelle (53) gebildet ist.

5. Koppelanordnung nach Anspruch 2 oder 3, dadurch gekennzeichnet, daß jede sechzehn Zubringer-Leitungen und eine Abnehmer-Leitung aufweisende Koppelpunktpyramide mit zwei jeweils zwei 4-Bit-Multiplexer aufweisenden 4-Bit-Multiplexer-Zellen und einer wenigstens drei 2-Bit-Multiplexer aufweisenden 2-Bit-Multiplexer-Zelle gebildet ist.

6. Koppelanordnung nach einem der Ansprüche 1 bis 5, dadurch gekennzeichnet, daß bei jeder Koppelpunktpyramide (KPP) ein zusätzlicher Umschaltkoppelpunkt (11) vorgesehen ist, der mit seiner einen Schaltstrecke in die Abnehmer-Leitung (t-11) der Koppelpunktpyramide (KPP) eingefügt ist.

7. Koppelanordnung nach Anspruch 6, dadurch gekennzeichnet, daß die andere Zubringer-Klemme (z) des zusätzlichen Umschaltkoppelpunktes (11) mit der Abnehmer-Leitung (tt') einer weiteren Koppelpunktpyramide (KPP') verbunden ist.

8. Koppelanordnung nach Anspruch 6 oder 7, dadurch gekennzeichnet, daß bei einer Vermittlung bzw. Verteilung von Kommunikationssignalen in Form von frequenzmodulierten Signalen bei Nichtdurchschaltung eines solchen Kommunikationssignals zu der Abnehmer-Klemme (tt) der Koppelpunktpyramide (KPP) über die andere Zubringer-Klemme (z) des zusätzlichen Umschaltkoppelpunktes (11) ein unmoduliertes Trägersignal (U) zugeführt wird.

9. Koppelanordnung nach einem der Ansprüche 6 bis 8, dadurch gekennzeichnet, daß der Umschaltkoppelpunkt durch eine 2-Bit-Multiplexer-Zelle (11) gebildet ist.

10. Koppelanordnung nach einem der vorhergehenden Ansprüche, dadurch gekennzeichnet, daß jeweils eine erste Gruppe von Koppelpunktpyramiden (KPP1 ... KPP4) mit nichtinvertierten Zubringersignalen beaufschlagt ist und eine zweite Gruppe von Koppelpunktpyramiden (KPP5 ... KPP8), deren Abnehmersignale dann invertiert werden, mit invertierten Zubringersignalen beaufschlagt ist.

**Claims**

1. A switching arrangement for the switching or distribution of communications signals in communications switching systems, characterised by the combination of the following features :
the switching arrangement is a wide-band switching arrangement having switching circuits (51, 52, 53) which are constructed in ECL technology and which are formed by controllable multiplexers (511, 512, 521, 522, 531) which can each be brought into a specific switch-through state,
the controllable multiplexers (511, 512, 521, 522, 531) are connected to one another to form switching point pyramids (KPP) which each comprise one outgoing line (t-tt) and a plurality of incoming lines (p1 ... p16),
the controllable multiplexers (511, 512, 521, 522, 531) of a plurality of switching point pyramids (KPP1 ... KPP8) are combined on a chip module.

2. A switching arrangement as claimed in claim 1, characterised in that the chip module is formed by a master-slice module which includes a plurality of controllable multiplexers (511, 512, 521, 522, 531).

3. A switching arrangement as claimed in claim 2, characterised in that the switching point circuits (151, 152, 153 ... 851, 852, 853) of eight switching point pyramids (KPP1 ... KPP8) which each comprise one outgoing line (tt1 ... tt8) and sixteen common incoming lines (p1 ... p16) are combined on one master-slice module.

4. A switching arrangement as claimed in claim 2 or 3, characterised in that each switching point pyramid (KPP) which comprises sixteen incoming lines (p1 ... p16) and one outgoing line (t-tt) is formed by two 4-bit multiplexer cells (51, 52) which each include two 4-bit multiplexers (511, 512 ; 521, 522) and a third 4-bit multiplexer cell (53) which includes at least one 4-bit multiplexer (531).

5. A switching arrangement as claimed in claim 2 or 3, characterised in that each switching point pyramid which comprises sixteen incoming lines and one outgoing line is formed by two 4-bit multiplexer cells which each include two 4-bit multiplexers and by one 2-bit multiplexer cell which includes at least three 2-bit multiplexers.

6. A switching arrangement as claimed in one of the claims 1 to 5, characterised in that each switching point pyramid (KPP) is provided with one additional switch-over switching point (11) which is inserted by its one switching path into the outgoing line (t-11) of the switching point pyramid (KPP).

7. A switching arrangement as claimed in claim 6, characterised in that the other incoming terminal (z) of the additional switch-over switching point (11) is connected to the outgoing line (tt') of a further switching point pyramid (KPP').

8. A switching arrangement as claimed in claim 6 or 7, characterised in that when communications signals are switched or distributed in the form of frequency-modulated signals, when such a communication signal is not switched through to the outgoing terminal (tt) of the switching point pyramid (KPP) an unmodulated carrier signal (U) is supplied via the other incoming terminal (z) of the additional switch-over switching point (11).

9. A switching arrangement as claimed in one of the claims 6 to 8, characterised in that the switch-over switching point is formed by a 2-bit multiplexer cell (11).

10. A switching arrangement as claimed in one of the preceding claims, characterised in that a first group of switching point pyramids (KPP1 ... KPP4) is supplied with non-inverted incoming signals and a second group of switching point pyramids (KPP5 ... KPP8) whose outgoing signals are then inverted is supplied with inverted incoming signals.

### Revendications

1. Dispositif de couplage pour la commutation ou la répartition de signaux de commutation dans des systèmes de transmission d'informations, caractérisé par la combinaison des caractéristiques suivantes :

le dispositif de couplage est un dispositif de couplage à large bande comportant des circuits de points de couplage (51, 52, 53), qui sont réalisés selon la technique ECL et qui sont formés par des multiplexeurs (511, 512, 521, 522, 531) pouvant être commandés en étant placés dans un état déterminé d'interconnexion, et

les multiplexeurs (511, 512, 521, 522, 531) pouvant être commandés sont reliés entre eux de manière à former des pyramides (KPP) de points de couplage comportant chacune une ligne de départ (t-tt) et plusieurs lignes d'arrivée (p1 ... p7),

les multiplexeurs (511, 512, 521, 522, 531) pouvant être commandés et comportant chacun une multiplicité de pyramides (KPP1 ... KPP8) de points de couplage sont réunis sur un module formant microplaquette.

2. Dispositif de couplage suivant la revendication 1, caractérisé par le fait que le module formant microplaquette est constitué par un module intégré à partir d'une matrice standard contenant une multiplicité de multiplexeurs (511, 512, 521, 522, 531) pouvant être commandés.

3. Dispositif de couplage suivant la revendication 2, caractérisé par le fait que les circuits (151, 152, 153 ; ... ; 851, 852, 853) de points de couplage de huit pyramides (KPP1 ... KPP8) de points de couplage, comportant chacune une ligne de départ (tt1 ... tt8) et seize lignes communes d'arrivée (p1 ... p16) sont rassemblés sur un module intégré à partir d'une matrice standard.

4. Dispositif de couplage suivant la revendication 2 ou 3, caractérisé par le fait que chaque pyramide (KPP) de points de couplage comportant seize lignes d'arrivée (p1 ... p16) et une ligne de départ (t-tt) est formée par deux cellules de multiplexeurs à 4 bits (51, 52) comportant chacune deux multiplexeurs à 4 bits (511, 512 ; 521, 522), et par une troisième cellule de multiplexeurs à 4 bits (153), comportant au moins un multiplexeur à 4 bits (531).

5. Dispositif de couplage suivant la revendication 2 ou 3, caractérisé par le fait que chaque pyramide de points de couplage comportant seize lignes d'arrivée et une ligne de départ est formée par deux cellules de multiplexeurs à 4 bits comportant chacun deux multiplexeurs à 4 bits, et par une cellule de multiplexeurs à 2 bits comportant au moins trois multiplexeurs à 2 bits.

6. Dispositif de couplage suivant l'une des revendications 1 à 5, caractérisé par le fait que dans chaque pyramide (KPP) de points de couplage, il est prévu un point supplémentaire de couplage à inversion (11), qui est inséré par l'une de ses voies de commutation, dans la ligne de départ (t-11) de la pyramide (KPP) de points de couplage.

7. Dispositif de couplage suivant la revendication 6, caractérisé par le fait que l'autre borne d'arrivée (z) du point supplémentaire de couplage à inversion (11) est reliée à la ligne de départ (tt') d'une autre pyramide (KPP') de points de couplage.

8. Dispositif de couplage suivant la revendication 6 ou 7, caractérisé par le fait que dans le cas d'une commutation ou d'une répartition de signaux de communication sous la forme de signaux modulés en fréquence, dans le cas de la non-transmission directe d'un tel signal de commutation à la borne de départ (tt) de la pyramide (KPP) de points de couplage, un signal de porteuse (U) non modulé est envoyé par l'intermédiaire de l'autre borne d'arrivée (z) du point supplémentaire de couplage à inversion (11).

9. Point de couplage suivant l'une des revendications 6 à 8, caractérisé par le fait que le point de couplage à inversion est formé par une cellule de multiplexeurs à 2 bits (11).

10. Dispositif de couplage suivant l'une des revendications précédentes, caractérisé par le fait que respectivement un premier groupe de pyramides (KPP1 ... KPP4) de points de couplage est chargé par des signaux d'arrivée non inversés et qu'un second groupe de pyramides (KPP5 ... KPP8) de points de couplage, dont les signaux de départ sont inversés, est chargé par des signaux d'arrivée inversés.

# FIG 1

# FIG 2

0 086 434

# FIG 3

FIG 4

F I G 5

0 086 434